Europäisches Patentamt

European Patent Office

Office européen des brevets

(11) Numéro de publication: **0 181 265**
**B1**

(12) FASCICULE DE BREVET EUROPÉEN

(45) Date de publication du fascicule du brevet:
28.02.90

(21) Numéro de dépôt: 85402129.2

(22) Date de dépôt: 05.11.85

(51) Int. Cl. ⁵: **H 01 L 33/00, H 01 S 3/19**

(54) Dispositif optique à semi-conducteur et procédé d'émission de lumière.

(30) Priorité: 06.11.84 FR 8416891

(43) Date de publication de la demande:
14.05.86 Bulletin 86/20

(45) Mention de la délivrance du brevet:
28.02.90 Bulletin 90/09

(84) Etats contractants désignés:
DE FR GB IT NL

(56) Documents cité:
PHYSICAL REVIEW B, vol. 25, no. 9, 1 mai 1982, pages
5598-5606, The American Physical Society, New York,
US; U. KAUFMANN et al.: "Spectroscopic study of
vanadium in GaP and GaAs"
SOLID STATE COMMUNICATIONS, vol. 36, no. 2, 1980,
pages 171-172, Pergamon Press Ltd., GB; A. MIRCEA-
ROUSSEL et al.: "Optical absorption and
photoluminescence of vanadium in éta-type GaAs"
JOURNAL OF LUMINESCENCE, vol. 31-32, partie 1,
1984, pages 439-441, North-Holland Publishing,
Amsterdam, NL; G. GUILLOT et al.: "Decay of 3d
element internal photoluminescence transitions in III-
V semiconductors"
CHEMICAL ABSTRACTS, vol. 97, no. 26, 27 décembre
1982, page 690, no. 226319a, Columbus, Ohio, US; V.V.
USHAKOV et al.: "Luminescence of a titanium
impurity in gallium arsenide gallium phosphide", &
FIZ. TEKH. POLUPROVODN. (LENINGRAD) 1982,
16(9), 1633-5

(73) Titulaire: Etablissement Public dit: CENTRE NATIONAL
DE LA RECHERCHE SCIENTIFIQUE (CNRS)
15, Quai Anatole France
F-75007 Paris (FR)
Titulaire: ETAT FRANCAIS représenté par le Ministre des
PTT (Centre National d'Etudes des
Télécommunications)
38-40 rue du Général Leclerc
F-92131 Issy-les-Moulineaux (FR)

(72) Inventeur: Naud, Claude
2, rue des Champs
F-95460 Ezanville (FR)
Inventeur: Guillot, Gérard
13 bis, rue Saint-Isidore
F-69003 Lyon (FR)
Inventeur: Deveaud, Benoît
44, rue Duroux
F-22300 Lannion (FR)
Inventeur: Clerjaud, Bernard
18, rue des Chantereines
F-93100 Montreuil (FR)

(74) Mandataire: Bezault, Jean
Cabinet Netter 40, rue Vignon
F-75009 Paris (FR)

㊻ Documents cité (suite):
CHEMICAL ABSTRACTS, vol. 79, no. 4, 30 juillet 1973,
page 435, no. 24793t, Columbus, Ohio, US; V.L.
VOROB'EV et al.: "Doping gallium arsenide with
titanium", & ELEKTRON. TEKH., NAUCH.-TEKH. SB.,
MATER. 1972, NO. 1, 116-18

## Description

La présente invention concerne les dispositifs optiques destinés à émettre un rayonnement lumineux à partir d'un milieu semi-conducteur soumis à une excitation d'énergie contrôlée.

Les dispositifs optiques à semi-conducteurs, tels que les diodes électroluminescentes, les lasers à semi-conducteur, etc., ont pris un essor considérable au cours des dernières années. Ceci est le cas en particulier des lasers utilisables dans les télécommunications par fibres optiques.

L'un des problèmes qui se pose est de mettre au point des lasers propres à émettre dans la gamme de transparence des fibres optiques utilisées. Ainsi, l'utilisation de fibres optiques à base de silice nécessite des lasers émettant dans l'infrarouge dans la gamme de longueurs d'onde de 1,3 µm à 1,7 µm.

Les premiers lasers à semi-conducteur ont été réalisés avec des échantillons d'arséniure de gallium GaAs. Toutefois, les conditions d'obtention de l'effet laser étaient alors particulièrement draconiennes puisque cet effet ne pouvait être obtenu qu'à très basse température en régime d'impulsions à très faible taux de répétition.

Le fonctionnement des lasers GaAs en régime continu et à température ambiante a pu ensuite être obtenu mais au pris de structures complexes et hétérogènes que l'on appelle encore "hétérojonctions".

Outre le fait que les lasers GaAs présentent une structure complexe, il faut noter qu'ils ont pour inconvénient majeur de ne pas-émettre dans la gamme de transparence des fibres optiques (1,3 µm à 1,7 µm). En effet, les lasers GaAs classiques émettent à une longueur d'onde d'environ 0,9 µm qui correspond à l'émission de bord de bande du matériau, c'est-à-dire à la transition de la bande interdite située entre la bande de conduction et la bande de valence.

On sait également réaliser des lasers quaternaires GaInAsP émettant aux environs de 1,5 µm, mais le matériau semi-conducteur doit être associé à un substrat tel qu'un substrat InP.

La présente invention permet de réaliser un laser émettant aux environs de 1,5 µm avec un matériau dont la longueur d'onde correspondant à la transition bande de conduction - bande de valence est inférieure, typiquement de 0,87 µm pour GaAs.

On peut ainsi obtenir l'effet laser avec un tel matériau sans être contraint d'utiliser l'émission de bord de la bande interdite.

L'invention repose sur la découverte surprenante qu'un milieu semi-conducteur dopé, en lui-même connu et utilisé jusqu'à présent comme substrat, pouvait être utilisé comme dispositif optique dans des conditions d'excitation d'énergie contrôlée. Un tel dispositif optique peut être réalisé aussi bien sous la forme d'un laser que d'une diode électroluminescente.

Le milieu semi-conducteur, qui est à la base de l'invention, est un alliage semi-conducteur binaire, ternaire ou quaternaire dopé, à savoir un alliage semi-conducteur III - V formé d'au moins un élément de la colonne III et d'au moins un élément de la colonne V de la Classification Périodique, et dopé au Vanadium, au Titane ou au Niobium.

Le dopant Vanadium, Titane ou Niobium est prévu dans une concentration de $10^{14}$ à $10^{17}$ atomes par $cm^3$ de l'alliage semi-conducteur non dopé. Cet alliage semi-conducteur doit être d'une pureté telle qu'il contienne moins de $10^{16}$ atomes d'impuretés indésirées par $cm^3$.

L'élément de la colonne III est avantageusement le Gallium ou l'Indium, ou éventuellement l'Aluminium et celui de la colonne V l'Arsenic ou le Phosphore.

Les alliages semi-conducteurs préférés selon l'invention sont les alliages binaires GaP, GaAs et InP, avec une préférence particulière pour GaAs, tout au moins pour l'application au laser.

Pour les alliages ternaires, on peut mentionner $Ga_{1-x}, Al_x, As$ et $Ga, As_{1-x}, P_x$ et pour les alliages quaternaires on peut mentionner $Ga_{1-x}, In_x, As_{1-y}, P_y$.

On a pu constater que l'émission lumineuse obtenue avec le dispositif optique de l'invention est une émission luminescente correspondant à une émission interne du Vanadium sous forme de $V^{3+}$, laquelle correspond à une longueur d'onde comprise entre 1,5 et 1,8 µm selon le matériau utilisé.

L'invention s'écarte ainsi totalement du document Physical Review B. Vol. 25, n° 9, 1982, pages 5598 - 5600 dont les auteurs indiquent expressément que c'est le Vanadium sous forme de $V^{2+}$ qui est responsable d'une émission photoluminescente dans un semi-conducteur du type GaP ou GaAs dopé au Vanadium.

Dans le cas où le dopant est le Titane, il s'agit d'une émission interne du Titane sous forme $Ti^{2+}$ ou $Ti^{3+}$. Si le dopant est le Niobium, il s'agit d'une émission interne du Niobium sous forme $Nb^{3+}$.

La transmission responsable de cette émission luminescente n'est pas entièrement comprise. Il semble qu'il s'agisse d'une transition 1E ou 3T2 → 3A2 (dans le cas de $V^{3+}$, $Ti^{2+}$, et $Nb^{3+}$) et d'une transition 2T2 → 2E (dans le cas de $Ti^{3+}$), la notation utilisée étant celle de Mulliken. Ainsi, au lieu d'utiliser une émission de bande à bande (transition bande de conduction-bande de valence), comme on le faisait antérieurement, on utilise, selon l'invention, une émission interne au dopant Vanadium, Titane ou Niobium.

Le milieu semi-conducteur de l'invention peut être un matériau massif, polycristallin, ou monocristallin, ou encore une couche épitaxiée sur un substrat constitué d'un alliage adapté pour établir un accord de maille des réseaux avec la couche épitaxiée.

L'invention prévoit en outre que le dispositif comporte des moyens pour exciter l'alliage semi-conducteur dopé avec une énergie contrôlée qui peut être supérieure ou inférieure à l'énergie de transition entre la bande de valence et la bande de conduction de l'alliage semi-conducteur non dopé.

Bien que le phénomène ne puisse être complètement expliqué, il apparaît qu'il se produit alors un transfert d'énergie entre les bandes d'énergie de l'alliage semi-conducteur et les niveaux d'énergie du dopant dont certains se trouvent localisés dans la bande interdite de l'alliage semiconducteur.

Dans une première variante de réalisation de l'invention, dans laquelle l'alliage dopé comporte une transition fortement absorbante propre à induire une transition radiative génératrice de ladite émission lumineuse, par l'intermédiaire d'une transition non radiative, le dispositif est alors agencé pour émettre un rayonnement lumineux cohérent à partir de ladite transition radiative.

Les moyens d'excitation prévus dans le cadre de cette variante peuvent comprendre des moyens de pompage optique à l'aide de photons dont les longueurs d'onde sont associées à des énergies inférieures à l'énergie de transition entre la bande de valence et la bande de conduction de l'alliage semi-conducteur (par exemple par un laser solide dopé Néodyme).

On peut également réaliser le pompage optique à l'aide de photons dont les longueurs d'onde sont associées à des énergies supérieures ou égales à l'énergie de transition entre la bande de valence et la bande de conduction de l'alliage semi-conducteur.

Pour ce faire, une solution consiste à prévoir que les moyens de pompage optique comprennent un laser à semi-conducteur dont le matériau actif est l'alliage de base non dopé. Dans ce cas, l'énergie de pompage est alors égale à l'énergie de transition précitée.

Dans une seconde variante de réalisation de l'invention, le dispositif est agencé sous la forme d'une diode électroluminescente et les moyens d'excitation précités comprennent des moyens pour injecter dans l'alliage semi-conducteur dopé des électrons possédant l'énergie précitée.

Il est également prévu, dans une troisième variante de réalisation de l'invention, que le dispositif soit agencé lui-même sous forme de laser à semi-conducteur, réalisant ainsi un "pompage électrique".

L'invention, sous un autre aspect, concerne un procédé d'émission de lumière par effet laser ou par électroluminescence, selon lequel on prépare un milieu semi-conducteur, constitué par un alliage semi-conducteur III - V, binaire, ternaire ou quaternaire, formé d'au moins un élément de la colonne III et d'au moins un élément de la colonne V de la Classification Périodique, et dopé par un dopant Vanadium, Titane ou Niobium dans lequel le dopant est prévu dans une concentration de $10^{14}$ à $10^{17}$ atomes par $cm^3$ de l'alliage semi-conducteur et cet alliage contient moins de $10^{16}$ atomes d'impuretés indésirées par $cm^3$; et on excite ce milieu semi-conducteur par une excitation d'énergie contrôlée supérieure au seuil de l'une des deux transitions fortement absorbantes dont est capable ledit milieu.

L'invention sera mieux comprise à la lecture de la description détaillée qui suit et qui se réfère aux dessins annexés, sur lesquels:

- la figure 1 représente un spectre d'absorption d'un alliage GaAs dopé au Vanadium;
- la figure 2 représente un autre spectre d'absorption établi avec le même milieu semiconducteur que dans la figure 1, mais avec une sensibilité plus élevée dans la région de la luminescence;
- la figure 3 représente un spectre d'émission obtenu avec le même milieu semi-conducteur que dans les figures 1 et 2;
- la figure 4 représente un spectre d'excitation de luminescence établi pour le même milieu semi-conducteur que pour les figures 1 à 3;
- la figure 5 est un diagramme représentant les variations des principaux niveaux d'énergie de $V^{3+}$ dans la configuration $3d^2$ dans un champ cristallin de symétrie Td;
- la figure 6 représente schématiquement un diagramme montrant la disposition relative des bandes d'énergie de l'alliage GaAs et des principaux niveaux d'énergie du dopant Vanadium sous forme $V^{3+}$.
- la figure 7 représente schématiquement un laser à semiconducteur pompé optiquement selon l'invention; et
- la figure 8 représente schématiquement un dispositif émetteur de lumière réalisé selon l'invention.

Les alliages semi-conducteurs III - V qui sont à la base de l'invention sont des matériaux connus en eux-mêmes.

En particulier, l'arséniure de gallium dopé au vanadium est disponible commercialement auprès de la firme Wacker Chemitronic (République Fédérale d'Allemagne).

Ce milieu semi-conducteur connu a toutefois été utilisé jusqu'à présent comme substrat pour des composants électroniques où ce milieu ne met alors en jeu que des signaux électriques.

Ce milieu semi-conducteur, qui s'est avéré particulièrement intéressant en raison de sa bonne stabilité thermique, a fait l'objet de différentes études, mais le rôle du dopant Vanadium qui n'a pas encore pu être véritablement compris, fait l'objet d'importantes controverses.

La littérature sur ce point peut être divisée grossièrement en deux classes principales, à savoir l'une qui considère que le vanadium introduit un niveau d'énergie au milieu de la bande interdite comprise entre la bande de valence et la bande de conduction de GaAs et l'autre qui localise le niveau accepteur à environ 0,2 eV en dessous de la bande de conduction. Le fait que les milieux soumis à l'étude aient été de deux sources différentes - l'une de résistivité élevée, l'autre de type n - ne peut suffire à expliquer ces différences d'interprétation.

Les études menées par les Demandeurs ont porté d'une part sur un matériau de base Wacker, d'autre part sur un matériau de type n, pris en deux lots d'échantillons de résistivités très différentes.

Le milieu semi-conducteur étudié de type n a été tiré par la méthode dite de Bridgman horizontale et a été dopé dans le bain à raison de 150 mg de vanadium pour 400 g de GaAs. On a trouvé que ce lingot était de type n, pratiquement sur toute sa longueur, la concentration en dopant étant d'environ $2 \times 10^{16}$ atomes de vanadium par $cm^3$ de l'alliage semi-conducteur.

L'étude entreprise a porté à la fois sur des échantillons issus de la partie de type n et de la partie de queue du lingot, qui était fortement résistive.

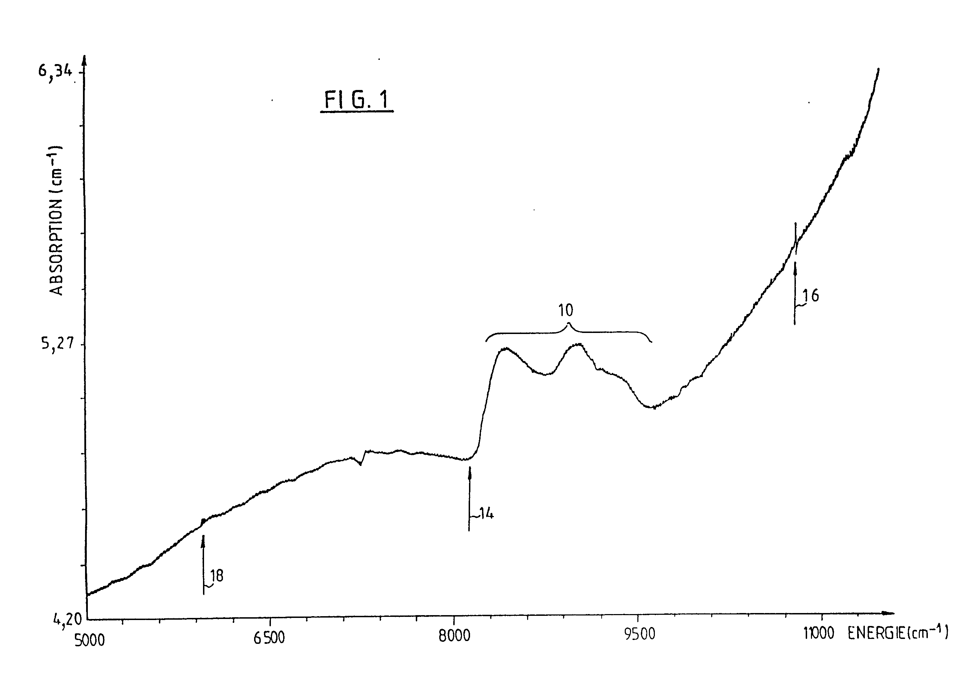

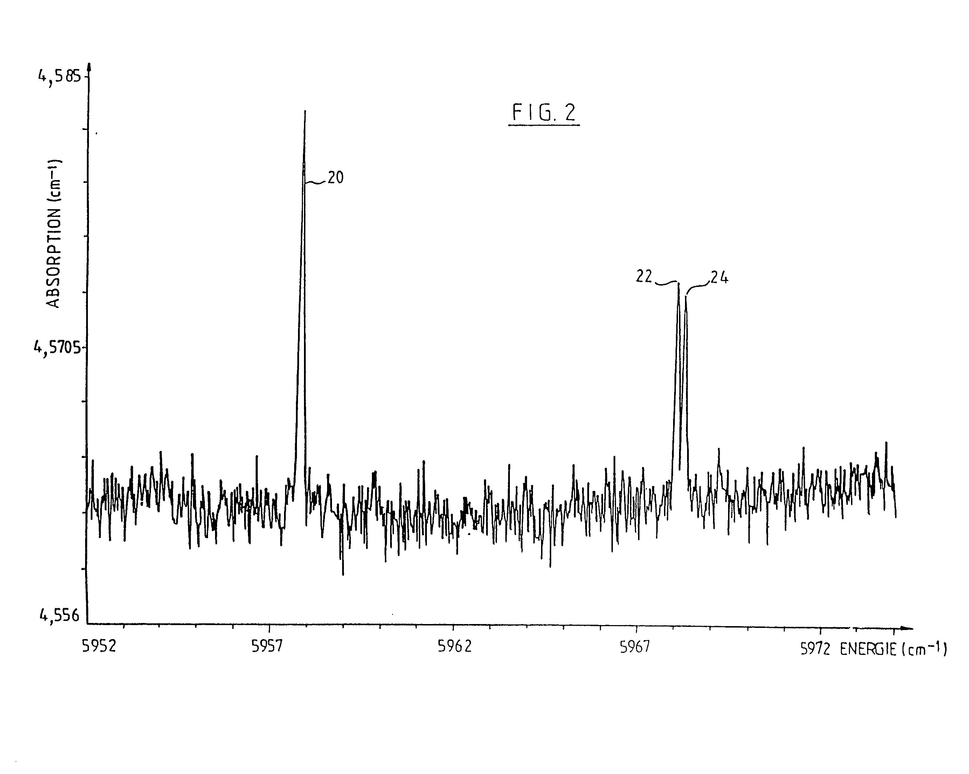

Les études menées par les Demandeurs ont montré que le spectre d'absorption est semblable pour les échantillons Wacker et les échantillons n fortement résistifs, et ce quelle que soit la source utilisée. Les figures 1 et 2 donnent cette forme globale à la température de 6K, pour les échantillons fortement résistifs.

Les échantillons n fortement conducteurs ont un spectre d'absorption différent (résistivités inférieures à 1000 $\Omega$cm).

Dans la suite, on désignera par "matériaux retenus" le matériau Wacker, le matériau de type n fortement résistif et le matériau de type p.

Les études faites en absorption, luminescence, excitation de luminescence, RPE (Résonance Paramagnétique Electronique) et DLTS (spectroscopie transitoire de niveau profond) ont alors montré qu'il existe dans GaAs un niveau accepteur localisé à environ 0,2 eV au-dessous de la bande de conduction.

La figure 1 représente les variations de l'absorption, exprimée en $cm^{-1}$, en fonction de l'énergie appliquée exprimée également en $cm^{-1}$.

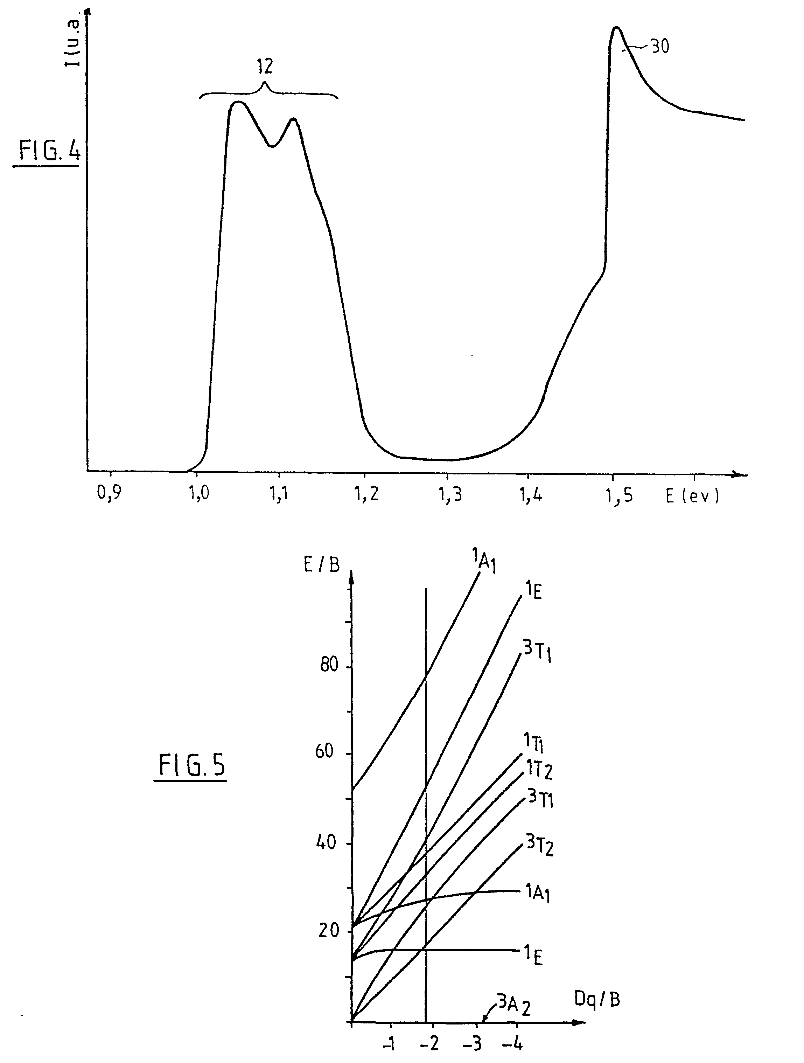

Ce spectre montre une bande d'absorption principale, désignée sous la référence générale 10, correspondant à une énergie appliquée d'environ 1,0 à 1,2 eV (8060 à 9672 $cm^{-1}$). Cette bande principale 10 présente une forme analogue à celle de la bande principale, désignée sous la référence 12, du spectre d'excitation de la luminescence représenté à la figure 4.

La raie zéro phonon associée à la bande principale 12 est désignée par la flèche 14 sur la figure 1. Cette raie zéro phonon a une largeur correspondant à 3 $cm^{-1}$ et est située à une énergie correspondant à 8131 ± 0,3 $cm^{-1}$.

Une raie étroite identifiée par la flèche 16 et correspondant à une énergie de 10773 ± 0,3 $cm^{-1}$ a également pu être observée sur tous les échantillons. Cette raie étroite, dont l'intensité est reliée à celle des autres raies, a une largeur correspondant à 0,5 $cm^{-1}$.

La région de la luminescence du spectre d'absorption de la figure 1 correspond à un intervalle d'énergie d'environ 5957 à 5968 $cm^{-1}$.

Cette région, identifiée par la flèche 18 sur la figure 1, apparaît en détail sur la figure 2 qui montre le même spectre établi avec une plus grande sensibilité.

L'examen de ce spectre montre une raie 20 à basse énergie, à savoir 5957,85 ± 0,3 $cm^{-1}$, et un composant à haute énergie qui se dédouble en deux raies 22 et 24 situées respectivement à

5968,05 $cm^{-1}$ et 5968,25 ± 0,3 $cm^{-1}$. On peut remarquer que ces raies sont extrêmement étroites (0,1 $cm^{-1}$) et que les raies dédoublées 22 et 24 sont séparées par un intervalle correspondant à 0,2 $cm^{-1}$.

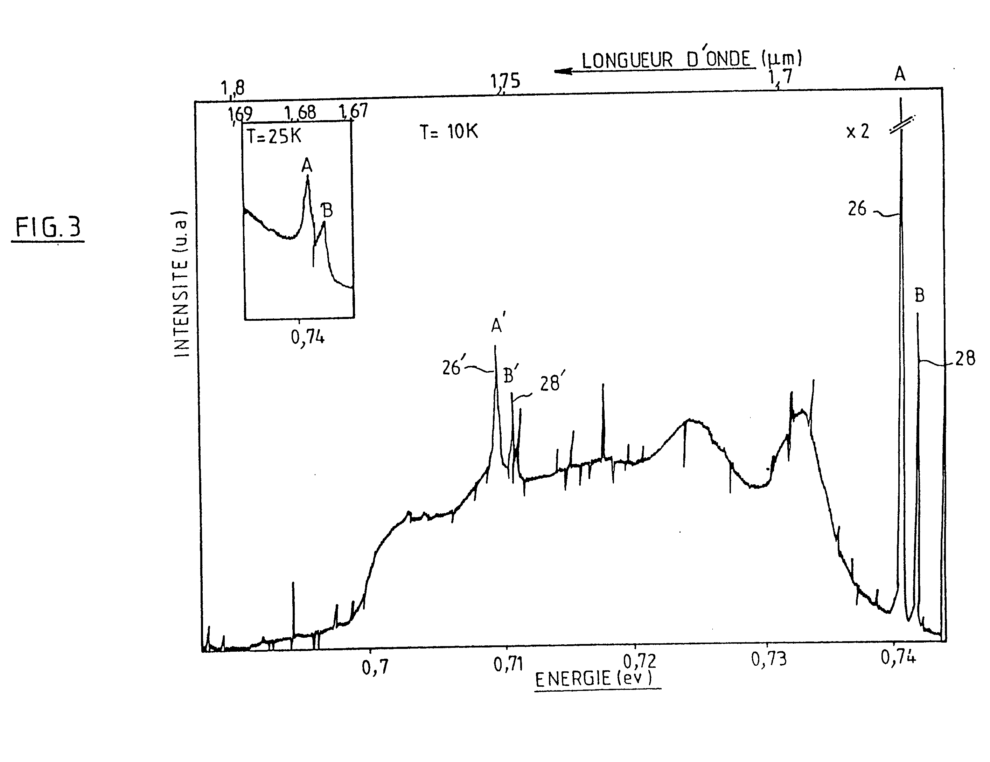

Ces raies coïncident exactement avec les raies zéro phonon de luminescence, désignées 26 et 28, sur le spectre de photoluminescence représenté sur la figure 3. Ce spectre qui montre l'intensité d'émission exprimée en unités arbitraires, en fonction de l'énergie ou de la longueur d'onde, a été obtenu à une température de 10 K sous excitation par un laser YAG.

Le spectre montre également des répliques assistées par phonon 26' et 28' des raies 26 et 28.

Les résultats expérimentaux permettent d'aboutir à deux enseignements principaux:

(1)     les transitions correspondant aux raies 20, 22 et 24 de la figure 2 sont extrêmement intenses en émission et très faibles en absorption;

(2)     les largeurs des raies zéro phonon sont extrêmement différentes en fonction de la transition, les raies de faible énergie étant remarquablement étroites.

L'explication avancée par les Demandeurs est que la caractéristique (1) montre que la transition radiative est interdite et qu'il n'y a pas de canaux non radiatifs, sinon la transition serait aussi très faible en émission: ceci peut donc suggérer une transition interdite par spin.

Le fait, d'autre part, que les largeurs des raies sont inhomogènes, semble signifier qu'elles sont gouvernées par les contraintes internes des cristaux.

La caractéristique (2) montre que la réponse des différentes raies zéro phonon aux contraintes internes des cristaux est extrêmement différente, les raies de faible énergie semblant très peu sensibles aux contraintes.

Le diagramme de Tanabe-Sugano de la figure 5 montre les variations des principaux niveaux d'énergie de $V^{3+}$ dans la configuration $3d^2$ dans un champ cristallin de symétrie Td en fonction des contraintes, les niveaux étant désignés conformément à la notation de Mulliken. On peut voir d'après ce diagramme que le niveau 1E(1D) est pratiquement parallèle au niveau fondamental 3A2.

En conséquence, l'énergie de transition 3A2(3F) ↔ 1E(1D) est très peu sensible aux distorsions ou contraintes symétriques.

En revanche, la transition autorisée 3A2(3F) ↔ 3TA(3F) doit être très sensible à de telles contraintes du fait que la pente du niveau 4T1 dans le diagramme de la figure 5 est assez accentuée. Il en est de même de la transition 3A2 ↔ 3T1 + 1A1.

Il faut également noter que le niveau 1A1(1G) présente une faible pente sur ce diagramme et que la transition 3A2(3F) ↔ 1A1(1G) devrait donc correspondre à une raie de faible largeur.

Le diagramme de Tanabe-Sugano de $V^{2+}$ ne permet pas une telle analyse.

Ces différents résultats ont conduit les Demandeurs à attribuer la transition de 5958 $cm^{-1}$ a une transition 3A2(3F) $\leftrightarrow$ 3T2 interdite, la bande principale avec la raie zéro phonon à 8131 $cm^{-1}$ une transition 3A2(3F) $\leftrightarrow$ 3T1 et la raie étroite à 10 773 $cm^{-1}$ à la transition 3A2(3F) $\leftrightarrow$ 1A1(1G) de $V^{3+}$ sur un site gallium.

L'interprétation avancée par les Demandeurs a pu être vérifiée en mesurant la durée de la luminescence. A 4,2 K, cette durée de vie est de 0,15 ms à un facteur 2 près pour tous les matériaux. Cette durée relativement longue confirme le caractère à interdiction de la transition émettrice, les durées de vies pour des transitions autorisées étant généralement extrêmement plus faibles. Ceci montre également que GaAs favorise l'effet laser.

D'autre part, les spectres d'excitation des bandes de luminescence typiques du vanadium étudiés précédemment ont été établis. Le spectre de la figure 4 représente la variation de l'émission, dont l'intensité I est exprimée en unités arbitraires, en fonction de l'énergie E d'excitation de luminescence exprimée en eV.

Le spectre de la figure 4 montre la bande 12 déjà signalée précédemment. Il s'agit d'une très importante bande d'excitation intrinsèque centrée autour de 1,1 eV. Cette bande d'excitation a un seuil à 1 eV et deux structures nettement visibles avec des maxima à 1,05 eV et 1,12 eV et une troisième moins nette à 1,16 eV. Elle possède exactement la même forme que la courbe d'absorption représentée sur la figure 1.

Le spectre montre en outre une bande 30 située à 1,5 eV.

La bande 12 peut être ainsi attribuée à l'absorption interne de la transition 3A2 $\rightarrow$ 3T1 de $V^{3+}$ tandis que la bande 30 peut être attribuée à l'absorption de la bande de valence à la bande de conduction de GaAs. Ceci montre la possibilité de réaliser un pompage électrique par injection de paires électron-trou.

D'après les résultats expérimentaux des Demandeurs, il apparaît que le Vanadium est à l'état $V^{3+}$, c'est-à-dire neutre, dans l'un et l'autre des "matériaux retenus" tels que définis plus haut, ce qui est contraire aux interprétations faites antérieurement. Ceci prouve donc que le Vanadium n'agit pas comme accepteur dans le milieu de l'intervalle de la bande interdite de l'alliage semiconducteur. On peut ainsi créer l'état de charge $V^{3+}$ du Vanadium en l'introduisant en quantité suffisante dans un matériau de type p, en particulier GaP, GaAs et InP.

Ce n'est donc pas le Vanadium qui rend le matériau semi-isolant. Dans InP, le vanadium n'est pas accepteur car le niveau potentiellement accepteur se situe au-dessus de la bande de conduction.

Des résultats expérimentaux comparables ont été obtenus avec les autres alliages semiconducteurs visés par l'invention et avec le Titane ou le Niobium utilisé comme dopant à la place du Vanadium.

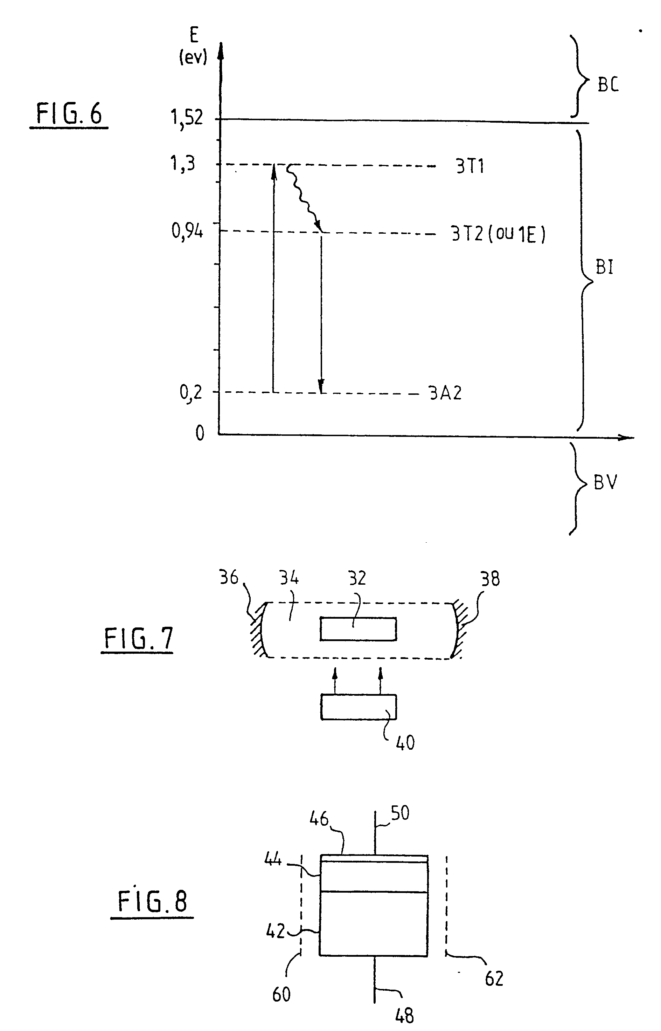

On se réfère maintenant au diagramme de la figure 6 (établi à la température de 6K) sur lequel BV, BI et BC désignent respectivement la bande de valence, la bande interdite et la bande de conduction de l'alliacé semi-conducteur. Les niveaux d'énergie 3A2, 3T2 et 3T1 du dopant Vanadium sous forme $V^{3+}$ sont également représentés sur ce diagramme. L'émission luminescente correspond à une émission interne du Vanadium sous forme $V^{3+}$. La transition responsable de cette émission est la transition 3T2 $\rightarrow$ 3A2. Un diagramme analogue est obtenu pour le Niobium sous forme $Nb^{3+}$, étant à noter que le niveau intermédiaire est 1E au lieu de 3T2.

Pour déclencher l'émission lumineuse, on peut utiliser plusieurs procédés.

- On peut exciter le milieu semi-conducteur pour faire passer des électrons du niveau 3A2 au niveau 3T1 (transition fortement absorbante). Il se produit ensuite une désexcitation qui implique d'abord un passage d'électrons du niveau 3T1 au niveau 3T2: il s'agit d'une transition très autorisée selon un processus non radiatif à phonons (vibrations du réseau). Cette transition non radiative est suivie par une transition radiative très interdite 3T2 $\rightarrow$ 3A2 avec émission de photons. Les résultats expérimentaux ont montré que la durée de vie de l'état intermédiaire ou émetteur 3T2 est relativement longue (0,18 ms à 4K). Ceci suggère une transition interdite.

Dans ce cas, l'énergie d'excitation est inférieure à l'énergie de transition entre la bande de valence et la bande de conduction. On peut utiliser avantageusement un laser YAG ou verre ou tout autre matériau dopé Néodyme.

- On peut encore exciter le milieu semiconducteur avec une énergie supérieure ou égale à l'énergie de transition entre la bande de valence et la bande de conduction, cette énergie correspondant au maximum (bande 30) de la courbe d'excitation de la luminescence (figure 4). On utilise alors un laser à semi-conducteur tel que GaAs non dopé traditionnel, ou encore un flash, ou tout autre laser notamment à gaz, pourvu que la fréquence du laser soit supérieure ou égale à un seuil qui correspond à l'énergie de transition précitée.

- On peut également exciter le milieu semiconducteur par injection de paires électron-trou dans ce milieu.

Avec les moyens d'excitation précités, on crée ainsi un transfert d'énergie entre les bandes de l'alliage semi-conducteur et le dopant Vanadium qui permet de l'amener dans un état excité sans que l'on soit obligé de réaliser des transitions internes à l'intérieur du dopant lui-même.

Le fait que le dopant Vanadium soit inclus dans une matrice qui est un semi-conducteur constitue aussi un avantage déterminant car, comme on vient de le voir précédemment, les paires électron-trou de l'alliage semi-conducteur sont responsables d'une excitation très efficace de la luminescence du Vanadium.

On peut ainsi réaliser un dispositif optique selon l'invention en combinant au milieu semi-conducteur, tel que défini précédemment, des moyens d'excitation propres à exciter l'alliage semi-conducteur dopé avec une énergie contrôlée qui peut être supérieure ou inférieure à l'énergie de transition entre la bande de valence et la bande de conduction de l'alliage semi-conducteur non dopé.

Le milieu semi-conducteur est connu en lui-même et peut être préparé suivant des procédés connus.

L'alliage semi-conducteur non dopé de départ doit être de grande pureté, c'est-à-dire qu'il doit contenir si possible moins de $10^{16}$ atomes d'impuretés indésirées par $cm^3$. La concentration du dopant Vanadium qui sera ajouté à cet alliage doit être comprise entre $10^{14}$ et $10^{17}$ atomes de Vanadium par $cm^3$ de l'alliage semi-conducteur.

Le milieu peut être rendu de type n ou p par introduction d'impuretés donneur ou accepteur.

Le milieu semi-conducteur peut être un matériau massif polycristallin ou monocristallin, ou bien encore une couche épitaxiée sur un substrat constitué d'un alliage adapté de manière à obtenir un accord de maille des réseaux avec la couche épitaxiée.

Le matériau massif est préparé en faisant croître le matériau semi-conducteur en présence d'un germe monocristallin. La couche épitaxiée est produite par exemple par la technique d'épitaxie en phase liquide pour faire croître le cristal de l'alliage semi-conducteur, y compris le dopant Vanadium, sur un substrat formé du même alliage.

Ces procédés de fabrication sont bien connus de l'homme de l'art et il n'entre pas dans le cadre de l'invention de les décrire en détail dans cette demande.

Dans une première variante de réalisation de l'invention, le dispositif est agencé pour émettre un rayonnement lumineux cohérent à partir de la transition radiative 3T2 → 3A2 (figure 6) en tirant profit du fait que le milieu semiconducteur comporte une transition fortement absorbante (3A2 → 3T1) propre à induire ladite transmission radiative (3T2 → 3A2) par l'intermédiaire d'une transition non radiative (3T1 → 3T2).

Pour cela, on excite le milieu semi-conducteur en l'éclairant par des photons dont l'énergie est au moins égale à l'énergie de transition entre les niveaux 3A2 et 3T1.

Une solution commode pour réaliser cet éclairage est d'utiliser des moyens de pompage optique à l'aide de photons dont les longueurs d'ondes sont associées à des énergies supérieures ou égales à l'énergie de transition définie précédemment.

Un dispositif réalisé de cette façon est représenté de façon très schématique sur la figure 7. Il comprend un milieu semi-conducteur 32 conforme à l'invention à l'intérieur d'une cavité laser 34, de forme allongée, délimitée à ses extrémités par des miroirs 36 et 38 partiellement réfléchissants. Une source 40 propre à réaliser le pompage optique du matériau est disposée latéralement par rapport à la cavité laser 34.

Cette source 40 émet des photons dont les longueurs d'ondes sont associées à des énergies propres à amener des électrons, directement ou indirectement au niveau 3T1.

Bien que la source 40 puisse être constituée par toute source laser émettant dans la longueur d'onde appropriée, un des moyens commodes est d'utiliser un laser à semi-conducteur dont le matériau actif est l'alliage de base non dopé. Ainsi, dans le cas d'un milieu semi-conducteur GaAs dopé au Vanadium, on aura tout avantage à utiliser une diode laser GaAs qui émettra les photons ayant précisément la bonne énergie pour réaliser le pompage optique du milieu semi-conducteur.

Dans une deuxième variante, le dispositif de l'invention est agencé sous la forme d'une diode électroluminescente et les moyens d'excitation définis plus haut sont des moyens pour injecter dans l'alliage semi-conducteur dopé des électrons possédant une énergie correspondant à l'énergie de transition entre la bande de valence et la bande de conduction de l'alliage semi-conducteur non dopé.

Un exemple d'une telle diode est représenté schématiquement sur la figure 8.

Elle comprend un substrat 42 de GaAs sur lequel est disposée une couche 44 de GaAs dopé au Vanadium, laquelle reçoit une couche 46 d'un matérial $p^+$ ou $n^+$. Deux électrodes 48 et 50 sont reliées respectivement au substrat 42 et à la couche 46. Une tension continue V ou des impulsions sont établies entre les deux électrodes pour provoquer l'émission lumineuse recherchée.

Dans un premier exemple, correspondant notamment à GaAs, le substrat 42 est de caractère $n^+$ la couche 44 de caractère p et la couche 46 de caractère $p^+$. Dans un deuxième exemple correspondant, notamment à InP, le substrat est de caractère $p^+$, la couche 44 de caractère n et la couche 46 de caractère $n^+$.

Dans une variante de ceci, le dispositif de l'invention est agencé lui-même sous forme de laser à semi-conducteur en réalisant ainsi ce que l'on appelle un pompage électrique. On réalise ainsi un dispositif optique intégré où le milieu semi-conducteur de l'invention et la diode laser réalisée à partir du même alliage semi-conducteur, mais non dopé, sont sur une même microstructure. Un tel dispositif peut être réalisé à partir de la diode décrite précédemment en utilisant les techniques actuelles à double hétérostructure.

La figure 8 l'illustre par des miroirs formant cavités, référencés 60 et 62. Ces miroirs peuvent être réalisés de toutes les manières connues de l'homme de l'art: miroirs externes ou définis par les faces latérales clivées du cristal, éventuellement revêtues d'un matériau convenable.

Les expériences entreprises par les Demandeurs ont montré que le dispositif de l'invention pouvait être agencé sous la forme d'un laser émettant aux longueurs d'ondes suivantes:

GaP : V 1,567 μm
GaAs : V 1,678 μm
InP : V 1,757 μm

Si l'on utilise du Titane comme dopant, on réalise des lasers émettant à une longueur d'onde un peu plus élevée, à savoir d'environ 2 µm.

Dans le cas où le Niobium est utilisé comme dopant, on réalise des lasers émettant à des longueurs d'onde de 1,55 µm 1,7 µm.

Le dispositif optique de l'invention peut être réalisé sous forme de diode électroluminescente ou sous forme de laser. Dans ce dernier cas, il trouve une application préférée dans le domaine des télécommunications par fibres optiques.

## Revendications

1. Dispositif optique destiné à émettre un rayonnement lumineux à partir d'un milieu semi-conducteur soumis à une excitation d'énergie contrôlée, caractérisé en ce que le milieu semi-conducteur est un alliage semi-conducteur III - V, binaire, tertiaire ou quaternaire, formé d'au moins un élément de la colonne III et d'au moins un élément de la colonne V de la Classification Périodique, et dopé par un dopant Vanadium, Titane ou Niobium, le dopant étant prévu dans une concentration de $10^{14}$ à $10^{17}$ atomes par $cm^3$ de l'alliage semi-conducteur, et cet alliage contenant moins de $10^{16}$ atomes d'impuretés indésirées par $cm^3$; et en ce que le milieu semi-conducteur dopé est excité de manière à constituer un laser ou bien une diode électroluminescente.

2. Dispositif selon la revendication 1, caractérisé en ce que l'émission lumineuse est une émission luminescente correspondant à une émission interne du Vanadium sous forme $V^{3+}$, du Titane sous forme $Ti^{2+}$ ou $Ti^{3+}$, ou du Niobium sous forme $Nb^{3+}$, correspondant à une longueur d'onde comprise entre 1,5 µm et 2,3 µm environ selon l'alliage et l'impureté utilisés.

3. Dispositif selon la revendication 2, caractérisé en ce que la transition responsable de ladite émission luminescente est une transition 1E ou 3T2 → 3A2 pour $V^{3+}$, $Ti^{2+}$ et $Nb^{3+}$ ou 2T2 → 2E pour $Ti^{3+}$, la notation utilisée étant celle de Mulliken.

4. Dispositif selon l'une quelconque des revendications 1 à 3, caractérisé en ce que l'alliage semi-conducteur est choisi parmi GaP, GaAs et InP et que le dopant est le Vanadium.

5. Dispositif selon l'une quelconque des revendications 1 à 4, caractérisé en ce que l'alliage semi-conducteur est GaAs et que le dopant est le Vanadium.

6. Dispositif selon l'une quelconque des revendications 1 à 5, caractérisé en ce que le milieu semi-conducteur est un matériau massif, polycristallin ou monocristallin.

7. Dispositif selon l'une quelconque des revendications 1 à 5, caractérisé en ce que le milieu semi-conducteur est une couche épitaxiée sur un substrat constitué d'un alliage adapté pour établir un accord de maille des réseaux avec la couche épitaxiée.

8. Dispositif selon l'une quelconque des revendications 1 à 7, caractérisé en ce qu'il comporte des moyens pour exciter l'alliage semi-conducteur dopé avec une énergie contrôlée.

9. Dispositif selon la revendication 8, caractérisé en ce que ledit alliage dopé comporte une transition fortement absorbante propre à induire une transition radiative génératrice de ladite émission lumineuse, par l'intermédiaire d'une transition non radiative, et qu'il est agencé pour émettre un rayonnement lumineux cohérent à partir de ladite transition radiative.

10. Dispositif selon la revendication 9, caractérisé en ce que les moyens d'excitation comprennent des moyens de pompage optique à l'aide de photons, dont les longueurs d'ondes sont associées à des énergies inférieures à l'énergie de transition entre la bande de valence et la bande de conduction de l'alliage semi-conducteur.

11. Dispositif selon la revendication 9, caractérisé en ce que les moyens d'excitation comprennent des moyens de pompage optique à l'aide de photons, dont les longueurs d'ondes sont associées à des énergies supérieures ou égales à l'énergie de transition entre la bande de valence et la bande de conduction de l'alliage semi-conducteur.

12. Dispositif selon la revendication 11, caractérisé en ce que les moyens de pompage optique comprennent un laser à semi-conducteur dont le matériau actif est l'alliage de base non dopé.

13. Dispositif selon la revendication 12, caractérisé en ce que le laser à semi-conducteur est un laser à GaAs.

14. Dispositif selon la revendication 12, caractérisé en ce que le laser à semi-conducteur est un laser à InP.

15. Dispositif selon la revendication 8, caractérisé en ce qu'il est agencé sous la forme d'une diode électroluminescente et que les moyens d'excitation comprennent des moyens pour injecter dans l'alliage semi-conducteur dopé des électrons possédant ladite énergie.

16. Dispositif selon la revendication 11, caractérisé en ce qu'il est agencé lui-même sous forme de laser à semi-conducteur.

17. Procédé d'émission de lumière par effet laser ou par electroluminescence, caractérisé en ce qu'on prépare un milieu semi-conducteur, constitué par un alliage semi-conducteur III - V, binaire, ternaire ou quaternaire formé d'au moins un élément de la colonne III et d'au moins un élément de la colonne V de la Classification Périodique, et dopé par un dopant Vanadium, Titane ou Niobium dans lequel le dopant est prévu dans une concentration de $10^{14}$ à $10^{17}$ atomes par $cm^3$ de l'alliage semi-conducteur et cet alliage contient moins de $10^{16}$ atomes d'impuretés indésirées par $cm^3$, et en ce qu'on excite ce milieu semi-conducteur par une excitation d'énergie contrôlée supérieure au seuil de l'une des deux transitions fortement absorbantes dont est capable ledit milieu.

**Patentansprüche**

1. Optische Vorrichtung für die Emission einer Lichtstrahlung aus einem Halbleiter-Milieu, das durch kontrollierte Energie angeregt wird, dadurch gekennzeichnet, daß es sich bei dem Halbleitermilieu um eine binäre, ternäre oder quaternäre III - V-Halbleiterlegierung handelt, die besteht aus mindestens einem Element der Gruppe III und mindestens einem Element der Gruppe V des Periodischen Systems der Elemente und die dotiert ist mit Vanadin, Titan oder Niob als Dotierungsmittel, das in einer Konzentration von $10^{14}$ bis $10^{17}$ Atomen pro $cm^3$ Halbleiterlegierung vorliegt, wobei diese Legierung pro $cm^3$ weniger als $10^{16}$ Atome von unerwünschten Verunreinigungen enthält, und daß das dotierte Halbleitermilieu so angeregt wird, daß ein Laser oder auch eine Elektrolumineszenz-Diode entsteht.

2. Vorrichtung nach Anspruch 1, dadurch gekennzeichnet, daß es sich bei der Lichtemission um eine Lumineszenzemission handelt, die einer internen Emission des Vanadins in Form von $V^{+3}$, des Titans in Form von $Ti^{2+}$ oder $Ti^{3+}$ oder des Niobs in Form von $Nb^{3+}$ entsprechend einer Wellenlänge zwischen etwa 1,5 µm und etwa 2,3 µm bei der Legierung und den verwendeten Verunreinigungen entspricht.

3. Vorrichtung nach Anspruch 2, dadurch gekennzeichnet, daß es sich bei dem für die Lumineszenzemission verantwortlichen Übergang um einen Übergang 1E oder 3T2 → 3A2 für $V^{3+}$, $Ti^{2+}$ und $Nb^{3+}$ oder 2T2 → 2E für $Ti^{3+}$ handelt entsprechend der Bezeichnung nach Mulliken.

4. Vorrichtung nach einem der Ansprüche 1 bis 3, dadurch gekennzeichnet, daß die Halbleiterlegierung ausgewählt wird aus GaP, GaAs und InP und daß es sich bei dem Dotierungsmittel um Vanadin handelt.

5. Vorrichtung nach einem der Ansprüche 1 bis 4, dadurch gekennzeichnet, daß es sich bei der Halbleiterlegierung um GaAs und bei dem Dotierungsmittel um Vanadin handelt.

6. Vorrichtung nach einem der Ansprüche 1 bis 5, dadurch gekennzeichnet, daß es sich bei dem Halbleitermilieu um ein polykristallines oder monokristallines massives Material handelt.

7. Vorrichtung nach einem der Ansprüche 1 bis 5, dadurch gekennzeichnet, daß es sich bei dem Halbleitermilieu um eine Schicht handelt, die epitaxial auf ein Substrat aufgebracht ist, das besteht aus einer Legierung, die geeignet ist für die Herstellung einer Übereinstimmung in dem Maschengitter mit der epitaxial aufgebrachten Schicht.

8. Vorrichtung nach einem der Ansprüche 1 bis 7, dadurch gekennzeichnet, daß sie Einrichtungen aufweist zum Anregen der dotierten Halbleiterlegierung mit einer kontrollierten Energie.

9. Vorrichtung nach Anspruch 8, dadurch gekennzeichnet, daß die dotierte Legierung einen stark absorbierenden Übergang aufweist, der geeignet ist, einen Strahlungsübergang zu induzieren, der die Lichtemission erzeugt durch einen Nicht-Strahlungsübergang und daß sie bestimmt ist für die Emission einer kohärenten Lichtstrahlung aufgrund des Strahlungsübergangs.

10. Vorrichtung nach Anspruch 9, dadurch gekennzeichnet, daß die Anregungseinrichtungen umfassen Einrichtungen zum optischen Pumpen mit Hilfe von Photonen, deren Wellenlängen Energien zugeordnet sind, die niedriger sind als die Übergangsenergie zwischen der Valenzbande und der Leitungsbande der Halbleiterlegierung.

11. Vorrichtung nach Anspruch 9, dadurch gekennzeichnet, daß die Anregungseinrichtungen umfassen Einrichtungen zum optischen Pumpen mittels Photonen, deren Wellenlängen Energien zugeordnet sind, die gleich oder höher sind als die Übergangsenergie zwischen der Valenzbande und der Leitungsbande der Halbleiterlegierung.

12. Vorrichtung nach Anspruch 11, dadurch gekennzeichnet, daß die Einrichtungen zum optischen Pumpen umfassen einen Halbleiter-Laser, dessen aktives Material die nicht-dotierte Basislegierung ist.

13. Vorrichtung nach Anspruch 12, dadurch gekennzeichnet, daß es sich bei dem Halbleiter-Laser um einen GaAs-Laser handelt.

14. Vorrichtung nach Anspruch 12, dadurch gekennzeichnet, daß es sich bei dem Halbleiter-Laser um einen InP-Laser handelt.

15. Vorrichtung nach Anspruch 8, dadurch gekennzeichnet, daß sie die Form einer Elektrolumineszenz-Diode hat und daß die Anregungseinrichtungen umfassen Einrichtungen zum Injizieren von Elektronen, welche diese Energie haben, in die dotierte Halbleiterlegierung.

16. Vorrichtung nach Anspruch 11, dadurch gekennzeichnet, daß sie selbst die Form eines Halbleiter-Lasers hat.

17. Verfahren zum emittieren von Licht durch einen Laser-Effekt oder durch Elektrolumineszenz, dadurch gekennzeichnet, daß man ein Halbleitermaterial erzeugt, das von einer binären, ternären oder quaternären Halbleiterlegierung III - V gebildet wird, die aus wenigstens einem Element der Gruppe III und wenigstens einem Element der Gruppe V des periodischen Systems besteht und durch ein Vanadium-, Titan- oder Niob-Dotierungsmittel dotiert ist, in welchem das Dotierungsmittel in einer Konzentration von $10^{14}$ bis $10^{17}$ atome/cm$^3$ der Halbleiterlegierung enthalten ist, und daß diese Legierung wenigstens $10^{16}$ unerwünschte Verunreinigungsatome pro cm$^3$ enthält, und daß man dieses Halbleitermedium mit Hilfe einer kontrollierten Erregungsenergie erregt, die höher ist als der Schwellenwert von einem der zwei stark absorbierenden Übergange ist, deren das genannte Milieu fähig ist.

**Claims**

1. An optical device adapted to emit a luminous radiation starting from a semiconductor medium subjected to a controlled energy excitation, characterised in that the semiconductor medium is a binary tertiary or quaternary semiconductor alloy III - V, formed from at least one element of group III and of at least one element of group V of the periodic system, and doped with a vanadium, titanium or niobium dopant, the dopant being provided in a concentration of $10^{14}$ to $10^{17}$ atoms per cm$^3$ of the semiconductor alloy, and this alloy containing less than $10^{16}$ atoms of unwanted impurities per cm$^3$, and in that the doped semiconductor medium is excited in such a manner as to constitute a laser or a light emitting diode.

2. A device according to Claim 1, characterised in that the luminous emission is a luminescent emission corresponding to an internal emission of the vanadium in the form $V^{3+}$, of the titanium in the form $Ti^{2+}$ or $Ti^{3+}$ or of the niobium in the form $Nb^{3+}$, corresponding to a wavelength comprised between about 1.5 μm and 2.3 μm according to the alloy and the impurity used.

3. A device according to Claim 2, characterised in that the transition responsible for said luminescent emission is a transition 1E or 3T2 → 3A2 for $V^{3+}$, $T1^{2+}$ and $Nb^{3+}$ or 2T2 → 2E for $Ti^{3+}$, the notation used being that of Mulliken.

4. A device according to any one of Claims 1 to 3, characterised in that the semiconductor alloy is selected from among GaP, GaAs and InP and that the dopant is vanadium.

5. A device according to any one of Claims 1 to 4, characterised in that the semiconductor alloy is GaAs and that the dopant is vanadium.

6. A device according to any one of Claims 1 to 5, characterised in that the semiconductor medium is a polycrystalline or monocrystalline solid material.

7. A device according to any one of Claims 1 to 5, characterised in that the semiconductor medium is a layer grown epitaxially on a substrate consisting of an alloy adapted to establish accordance between the mesh of the networks and the epitaxially grown layer.

8. A device according to any one of Claims 1 to 7, characterised in that it comprises means for exciting the doped semiconductor alloy with a controlled energy.

9. A device according to Claim 8, characterised in that said doped alloy comprises a highly absorptive transition adapted to induce a radiative transition generating said luminous emission, by means of a nonradiative transition, and that it is adapted to emit a coherent luminous radiation starting from said radiative transition.

10. A device according to Claim 9, characterised in that the excitation means comprise means for optical pumping by means of photons, the wavelengths of which are associated with energies lower than the energy of transition between the valence band and the conduction band of the semiconductor alloy.

11. A device according to Claim 9, characterised in that the excitation means comprise means for optical pumping by means of photons, the wavelengths of which are associated with energies greater than or equal to the energy of transition between the valence band and the conduction band of the semiconductor alloy.

12. A device according to Claim 11, characterised in that the optical pumping means comprise a junction laser, the active material of which is the undoped basic alloy.

13. A device according to Claim 12, characterised in that the junction laser is a GaAs laser.

14. A device according to Claim 12, characterised in that the junction laser is an InP laser.

15. A device according to Claim 8, characterised in that it is adapted in the form of a light emitting diode and that the excitation means comprise means for injecting electrons having said energy into the doped semiconductor alloy.

16. A device according to Claim 11 characterised in that it is itself adapted in the form of a junction laser.

17. A method of emitting light by laser effect or by electroluminescence, characterised in that a semiconductor medium is prepared consisting of a binary, ternary or quaternary semiconductor alloy III - V, formed from at least one element of group III and of at least one element of group V of the periodic system, and doped by a vanadium, titanium or niobium dopant, wherein the dopant is provided in a concentration of $10^{14}$ to $10^{17}$ atoms per $cm^3$ of the semiconductor alloy, and this alloy contains less than $10^{16}$ atoms of unwanted impurities per $cm^3$, and in that this semiconductor medium is excited by a controlled excitation of energy greater than the threshold of one of the two highly absorptive transitions of which said medium is capable.

FIG. 1

ABSORPTION ( cm⁻¹ )

6,34

5,27

4,20

10

16

14

18

5000    6500    8000    9500    11000    ENERGIE(cm⁻¹)

EP 0 181 265 B1

FIG. 2

FIG.3

LONGUEUR D'ONDE (µm)

EP 0 181 265 B1

FIG. 4

FIG. 5

FIG.6

FIG.7

FIG.8

9